# EUROPEAN PATENT APPLICATION

(11) **EP 4 716 394 A1**
(43) Date of publication of application: **25.03.2026**
(21) Application number: 25203505.0
(22) Date of filing: 19.09.2025
(51) Int. Cl.: H05K 7/20

(54) **PRECISE AND EFFICIENT COOLING SYSTEM CONTROL**

(30) Priority: 24.09.2024 US 202463698558 P
(71) Applicant: Vertiv Corporation, Westerville, OH 43082 (US)
(72) Inventor: COLE, Andrew Nathan, Westerville, 43082 (US)
(74) Representative: Cousens, Nico

(57) **Abstract**

A cooling system can include a first loop disposed at least partially within a space, such as a data center, a second loop disposed at least partially outside the space, and a heat exchanger for transferring heat from the first loop to the second loop. The first loop can include an evaporator for transferring heat from within the space to a first cooling fluid, and a prime mover for circulating the first cooling fluid within the first loop. The heat exchanger can transfer heat from the first cooling fluid to a second cooling fluid. The second loop can include a condenser for transferring heat from the second cooling fluid to an environment outside the space. The condenser can be disposed at a higher elevation than the heat exchanger and the second loop can operate as a thermosiphon.

## Description

This application claims the benefit of U.S. Provisional Patent Application No. 63/698,558 filed September 24, 2024.

### TECHNICAL FIELD

The present disclosure relates generally to cooling systems used in data centers, and more specifically relates to efficient and precise control of such cooling systems.

### BACKGROUND

Data center cooling systems are typically designed to remove heat from variable heat loads within the data center and expel that heat into a variable environment. Such variability is typically accommodated by turning off or on various fans, pumps, compressors, or the like. However, typical control schemes still consume power in operation and lack precise control at low heat loads and/or low environmental temperatures.

### SUMMARY

Applicant has created new and useful devices, systems and methods for precisely and efficiently controlling cooling systems, such as those used in data centers. In at least one embodiment, a cooling system according to the disclosure can include cascading inside and outside cooling loops. In at least one embodiment, the cooling system can include an economizer in the inside loop and/or a compressor in the outside loop. In at least one embodiment, the cooling system can operate the inside loop and/or the outside loop in a thermosiphon mode, such as with the compressor bypassed. In at least one embodiment, by adding the thermosiphon capability to the inside loop and/or the outside loop, more precise and/or more efficient control of the cooling system can be advantageously achieved, especially in low ambient temperatures and/or implementations with large temperature differences.

In at least one embodiment, at a zero cooling demand, any or all pumps and/or compressors, in the inside loop and/or the outside loop, can be deenergized and/or bypassed. In at least one embodiment, at a first cooling demand, a pump or other prime mover in the inside loop can be energized, with any economizer in the inside loop and/or compressor or other prime mover in the outside loop deenergized and/or bypassed, and the outside loop can be operated in a thermosiphon mode. In at least one embodiment, at a second cooling demand, an economizer in the inside loop can be brought online and/or a compressor in the outside loop can be deenergized and/or bypassed, and the outside loop can be operated in the thermosiphon mode. In at least one embodiment, at a third cooling demand, the economizer in the inside loop can be bypassed and/or the compressor in the outside loop can be brought online and/or energized, and the outside loop can be operated in a power-driven mode. In at least one embodiment, at a fourth cooling demand, the economizer in the inside loop and the compressor in the outside loop can be brought online and/or energized, and the outside loop can be operated in a power-driven mode for providing maximum cooling.

In at least one embodiment, decisions whether or not to operate the outside loop in the thermosiphon mode can be based on one or more temperatures and/or differential temperatures, such as when an outside ambient temperature is low enough for a thermosiphon to be effective and efficient, e.g., since power is not necessarily required to drive a thermosiphon. As another example, decisions whether or not to operate the outside loop in the thermosiphon mode can be based on a difference between a first temperature and a second temperature being too large for an economizing mode, and operating in thermosiphon mode across the cascade heat exchanger (e.g., a brazed plate heat exchanger (BPHE)) can allow precision operation of the first temperature to continue. In at least one embodiment, inclusion of the cascade heat exchanger can enable and/or cause the cooling system to operate through a second temperature drop, resulting in a larger total temperature drop. The larger total temperature drop can reduce the cooling capacity of the thermosyphon loop to a value closer to that of the inside loop, improving controllability of the cooling system.

In at least one embodiment, a cooling system according to the disclosure can extract heat from within a space, such as a data center, and expel the heat outside the space. In at least one embodiment, a cooling system according to the disclosure can include a first loop disposed at least partially within the space, a second loop disposed at least partially outside the space, a heat exchanger for transferring heat from the first loop to a second loop, or any combination thereof. In at least one embodiment, the first loop can include an evaporator for transferring heat from within a data center to a first cooling fluid, and/or a first prime mover, such as a pump or a compressor, for circulating the first cooling fluid within the first loop. In at least one embodiment, the heat exchanger can transfer heat from the first cooling fluid to a second cooling fluid. In at least one embodiment, the second loop can include a condenser for transferring heat from the second cooling fluid to an environment outside the data center. In at least one embodiment, the condenser can be mounted at a higher elevation than the heat exchanger, and the second loop can be configurable as a thermosiphon.

In at least one embodiment, a cooling system according to the disclosure can include a controller for monitoring a first temperature within the data center and/or a second temperature outside the data center. In at least one embodiment, the controller can control at least one valve and/or selectively operate the second loop in a thermosiphon mode. That is, in at least one embodiment, the controller can selectively operate the second loop in either the power-driven mode by energizing a compressor, or the thermosiphon mode by bypassing the compressor.

In at least one embodiment, the controller can operate the second loop according to the first temperature and/or the second temperature. In at least one embodiment, the controller can operate the second loop in a power-driven mode when the first temperature is above a first threshold and/or the second temperature is above a second threshold. In at least one embodiment, the controller can operate the second loop in the thermosiphon mode when the first temperature is below the first threshold and/or the second temperature is below the second threshold.

In at least one embodiment, the controller can operate the second loop according to a difference between the first temperature and the second temperature. In at least one embodiment, the controller can operate the second loop in a power-driven mode when a difference between the first temperature and the second temperature is below a threshold. In at least one embodiment, the controller can operate the second loop in the thermosiphon mode when the difference is above the threshold.

In at least one embodiment, the controller can operate the second loop according to the first temperature and/or the second temperature and a difference between the first temperature and the second temperature. In at least one embodiment, the controller can operate the second loop in the thermosiphon mode when the first temperature is below a first threshold and a difference between the first temperature and the second temperature is above a second threshold. In at least one embodiment, the controller can operate the second loop in the thermosiphon mode when a difference between the first temperature and the second temperature is above a first threshold and the second temperature is below a second threshold.

In at least one embodiment, the controller can operate the second loop in the power-driven mode by energizing a compressor and, alternatively, can operate the second loop in the thermosiphon mode by bypassing the compressor. In at least one embodiment, the at least one valve can include a bypass valve for bypassing the compressor. In at least one embodiment, the at least one valve can include a flow control valve for controlling flow through the second loop. In at least one embodiment, the second loop can include a second prime mover, such as a pump or a compressor, for circulating the second cooling fluid within the second loop and the at least one valve can include a bypass valve for selectively bypassing the second prime mover in order to selectively configure the second loop as the thermosiphon.

In at least one embodiment, a cooling system according to the disclosure can include a third loop disposed at least partially outside the data center and/or another heat exchanger for transferring heat from the first cooling fluid to a third cooling fluid. In at least one embodiment, the third loop can include a condenser for transferring heat from the third cooling fluid to the environment outside the data center and/or another prime mover, such as a pump or a compressor, for circulating the third cooling fluid within the third loop. In at least one embodiment, the at least one valve can include a flow control valve for controlling flow through the third loop. In at least one embodiment, the controller can control flow through the third loop using the flow control valve independently of the thermosiphon of the second loop.

In at least one embodiment, the first loop can include a fluid-side economizer for selectively transferring heat from the first cooling fluid to the environment outside the data center. In at least one embodiment, the economizer can share air flow with the condenser, such as in series. In at least one embodiment, the controller can bypass the economizer and operate the second loop in the thermosiphon mode when the first temperature and/or the second temperature is below a first and/or second threshold.

In at least one embodiment, the controller can bypass the economizer and operate the second loop in the thermosiphon mode when a difference between the first temperature and the second temperature is above a threshold. In at least one embodiment, the controller can bypass the economizer and operate the second loop in the thermosiphon mode when the first temperature is below a first threshold, the second temperature is below a second threshold, a difference between the first temperature and the second temperature is above a third threshold, or any combination thereof. In at least one embodiment, the economizer can be plumbed in parallel with the heat exchanger.

In at least one embodiment, the controller can utilize the economizer and operate the second loop in the thermosiphon mode when a difference between the first temperature and the second temperature is above a threshold. In at least one embodiment, the controller can utilize the economizer and operate the second loop in the thermosiphon mode when the first temperature is below a first threshold, the second temperature is below a second threshold, a difference between the first temperature and the second temperature is above a third threshold, or any combination thereof.

In at least one embodiment, a method according to the disclosure can include extract heat from a space, such as a data center, using a first loop at least partially within the space and a second loop at least partially outside the space. In at least one embodiment, a method according to the disclosure can including monitoring a first temperature within the data center, monitoring a second temperature outside the data center, energizing a prime mover in the second loop when the first temperature is above a first threshold, deenergizing the prime mover in the second loop when the second temperature is below a second threshold, or any combination thereof. In at least one embodiment, the first temperature can be indicative of a heat load within the data center and/or the second temperature can be indicative of an ambient temperature outside the data center.

In at least one embodiment, energizing the prime mover, such as a pump or a compressor, in the second loop can include operating the second loop in a power-driven mode, such as when the heat load within the data center is above the first threshold which can indicate a high heat load and/or cooling demand. In at least one embodiment, deenergizing the prime mover in the second loop can include operating the second loop in a thermosiphon mode, such as when the ambient temperature outside the data center is below the second threshold which can indicate cold weather or low ambient temperatures. In at least one embodiment, deenergizing the prime mover in the second loop can include deenergizing the prime mover in the second loop when the first temperature is below the first threshold and the second temperature is below the second threshold, and the second loop can be operated in the thermosiphon mode when the heat load within the data center is below the first threshold and the ambient temperature outside the data center is below the second threshold. In at least one embodiment, deenergizing the prime mover in the second loop can include deenergizing the prime mover in the second loop when a difference between the first temperature and the second temperature is above a third threshold and the second temperature is below the second threshold, and the second loop can be operated in the thermosiphon mode when a differential temperature across the data center is above the third threshold and the ambient temperature outside the data center is below the second threshold.

In at least one embodiment, a method according to the disclosure can include operating the second loop in a power-driven mode when a temperature inside the space is above a first threshold and/or operating the second loop in a thermosiphon mode when the temperature inside the space is below the first threshold. In at least one embodiment, operating the second loop in the thermosiphon mode can include bypassing a compressor in the second loop.

In at least one embodiment, a method according to the disclosure can include operating an economizer in the first loop when the temperature inside the space is below the first threshold and above a second threshold and/or when the temperature inside the space is above a third threshold. In at least one embodiment, the second threshold can be lower than the first threshold and/or the third threshold can be higher than the first threshold. In at least one embodiment, the economizer can transfer heat in the first loop to an environment outside the space.

In at least one embodiment, a method according to the disclosure can include operating the second loop in a power-driven mode when a first temperature inside the space is above a first threshold, operating the second loop in the power-driven mode when the first temperature inside the space is below the first threshold and above a second threshold and a difference between the first temperature inside the space and a second temperature outside the space is below a third threshold, operating the second loop in a thermosiphon mode when the first temperature inside the space is below the first threshold and above the second threshold and the difference between the first temperature inside the space and the second temperature outside the space is above the third threshold, operating the second loop in the thermosiphon mode when the first temperature inside the space is below the second threshold, or any combination thereof. In at least one embodiment, the second threshold can be lower than the first threshold. In at least one embodiment, operating the second loop in the thermosiphon mode can include bypassing a compressor in the second loop.

In at least one embodiment, a method according to the disclosure can include operating an economizer in the first loop when the temperature inside the space is above a fourth threshold, higher than the first threshold. In at least one embodiment, a method according to the disclosure can include operating an economizer in the first loop when the first temperature inside the space is below the first threshold and above a fifth threshold, between the first threshold and the second threshold. In at least one embodiment, the economizer can transfer heat in the first loop to an environment outside the space.

### BRIEF DESCRIPTION OF THE DRAWINGS

FIG. 1 is a simplified schematic view of one of many embodiments of a cooling system according to the disclosure.
FIG. 2 is a simplified schematic view of another one of many embodiments of a cooling system according to the disclosure.
FIG. 3 is a simplified schematic view of another one of many embodiments of a cooling system according to the disclosure.
FIG. 4 is a simplified schematic view of yet another of many embodiments of a cooling system according to the disclosure.
FIG. 5 is a simplified schematic view of still another of many embodiments of a cooling system according to the disclosure.
FIG. 6 is a simplified schematic view of another one of many embodiments of a cooling system according to the disclosure.
FIG. 7 is a flow chart of one of many embodiments of a control scheme for use with a cooling system according to the disclosure.
FIG. 8 is a flow chart of another one of many embodiments of a control scheme for use with a cooling system according to the disclosure.
FIG. 9 is a flow chart of yet another one of many embodiments of a control scheme for use with a cooling system according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's ultimate goal for the commercial embodiment. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various embodiments of the present disclosure. In this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of flowchart illustration can be implemented by special purpose hardware-based systems that perform the specified functions or acts, or combinations of special purpose hardware and computer instructions.

Applicant has created new and useful devices, systems and methods for precisely and efficiently controlling cooling systems, such as those used in data centers. In at least one embodiment, a cooling system according to the disclosure can include cascading inside and outside cooling loops. In at least one embodiment, the cooling system can include an economizer in the inside loop and/or a compressor in the outside loop. In at least one embodiment, the cooling system can operate the inside loop and/or the outside loop in a thermosiphon mode, such as with the compressor bypassed. In at least one embodiment, by adding the thermosiphon capability to the inside loop and/or the outside loop, more precise and/or more efficient control of the cooling system can be advantageously achieved, especially in low ambient temperatures and/or implementations with large temperature differences or low capacity. For example, by adding the extra thermal step of a thermosiphon that can have any subcooling or superheating required or desired for an implementation of the disclosure, the ability to adjust the effectiveness of the cascade heat exchanger's ability to transfer heat out of the inside loop can be improved and the over-transfer of heat can be minimized or prevented.

In at least one embodiment, at a zero cooling demand, any or all pumps and/or compressors, in the inside loop and/or the outside loop, can be deenergized and/or bypassed. In at least one embodiment, at a first cooling demand, a pump or other prime mover in the inside loop can be energized, with any economizer in the inside loop and/or compressor or other prime mover in the outside loop deenergized and/or bypassed, and the outside loop can be operated in a thermosiphon mode. In at least one embodiment, at a second cooling demand, an economizer in the inside loop can be brought online and/or a compressor in the outside loop can be deenergized and/or bypassed, and the outside loop can be operated in the thermosiphon mode. In at least one embodiment, at a third cooling demand, the economizer in the inside loop can be bypassed and/or the compressor in the outside loop can be brought online and/or energized, and the outside loop can be operated in a power-driven mode. In at least one embodiment, at a fourth cooling demand, the economizer in the inside loop and the compressor in the outside loop can be brought online and/or energized, and the outside loop can be operated in a power-driven mode for providing maximum cooling. In at least one embodiment, decisions whether or not to operate the outside loop in the thermosiphon mode can be based on one or more temperatures and/or differential temperatures, such as when an outside ambient temperature is low enough for a thermosiphon to be effective and efficient, e.g., since power is not necessarily required to drive a thermosiphon.

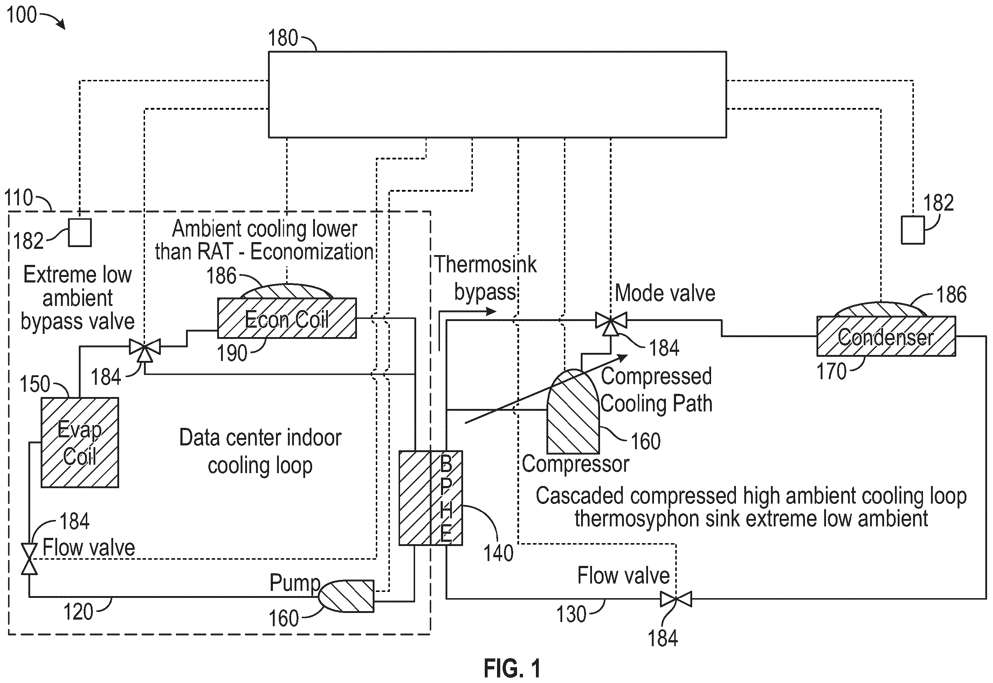

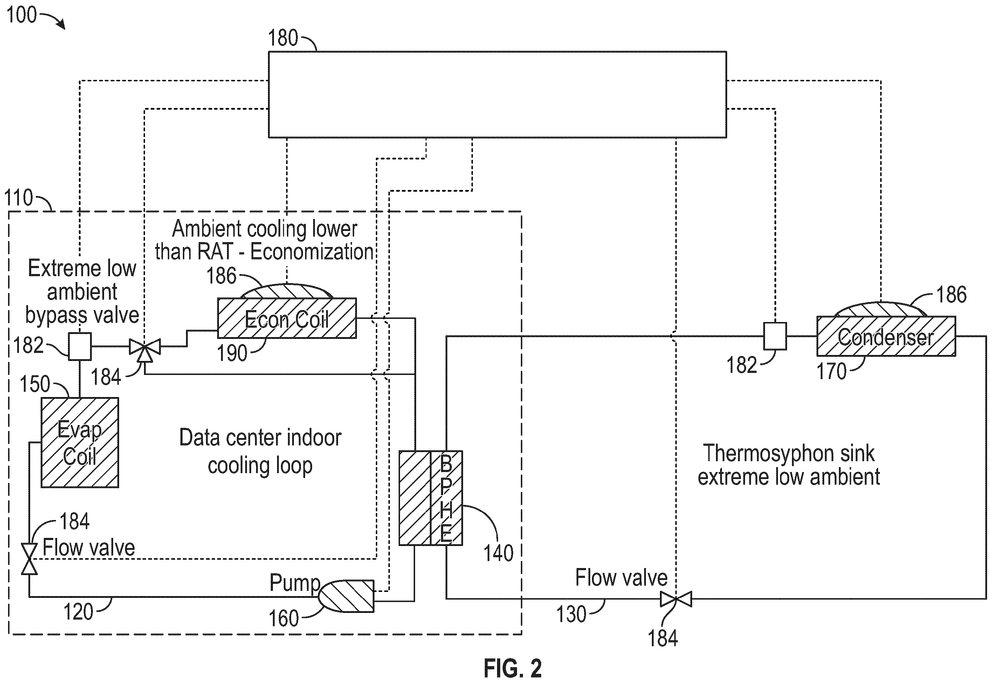

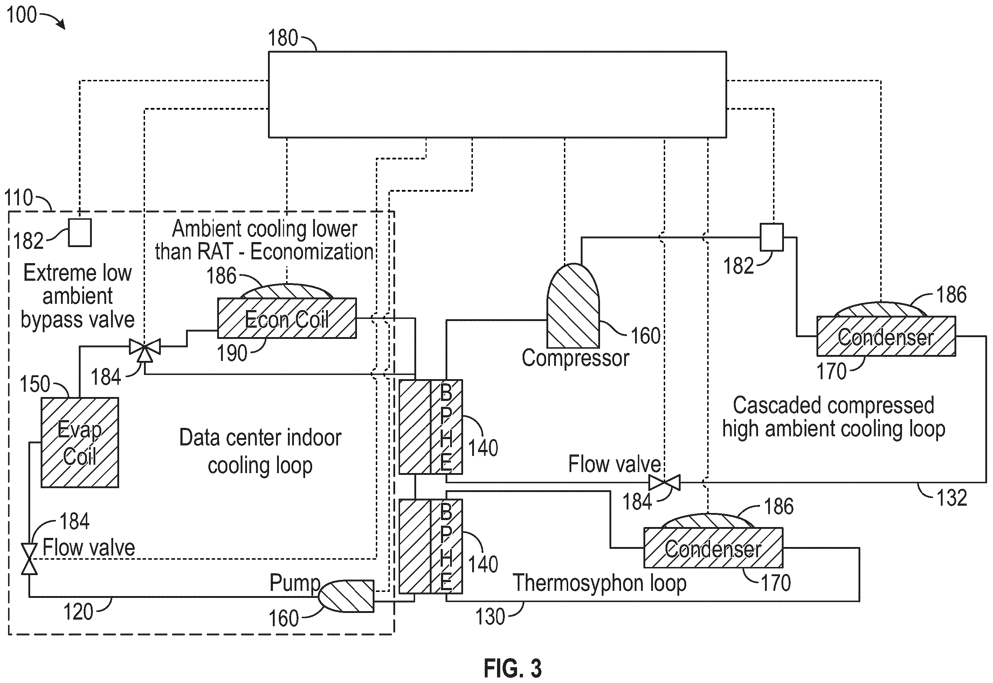

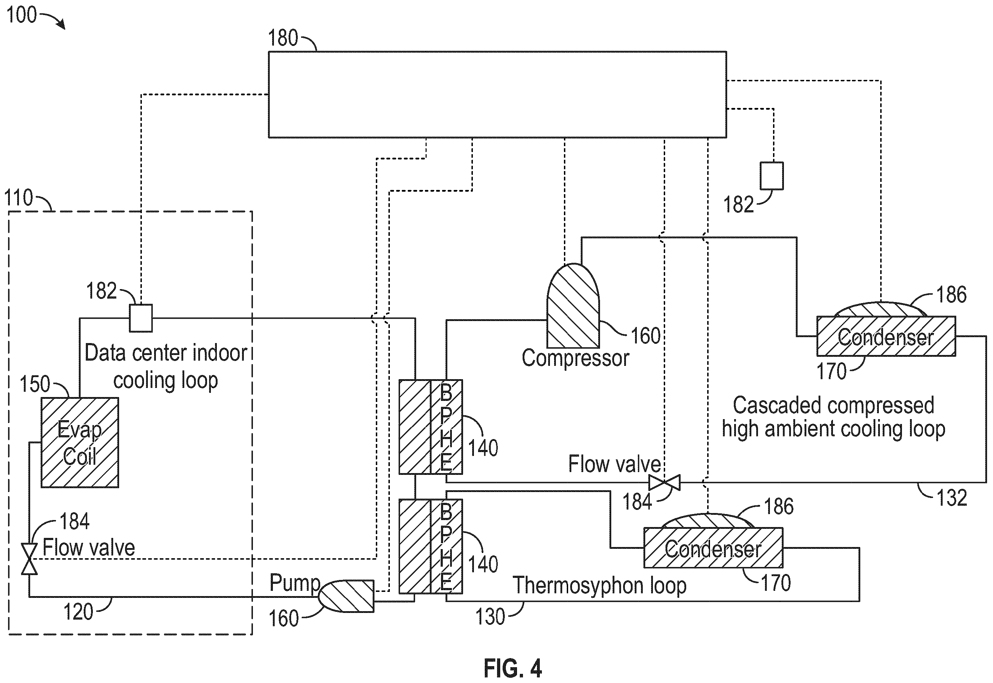

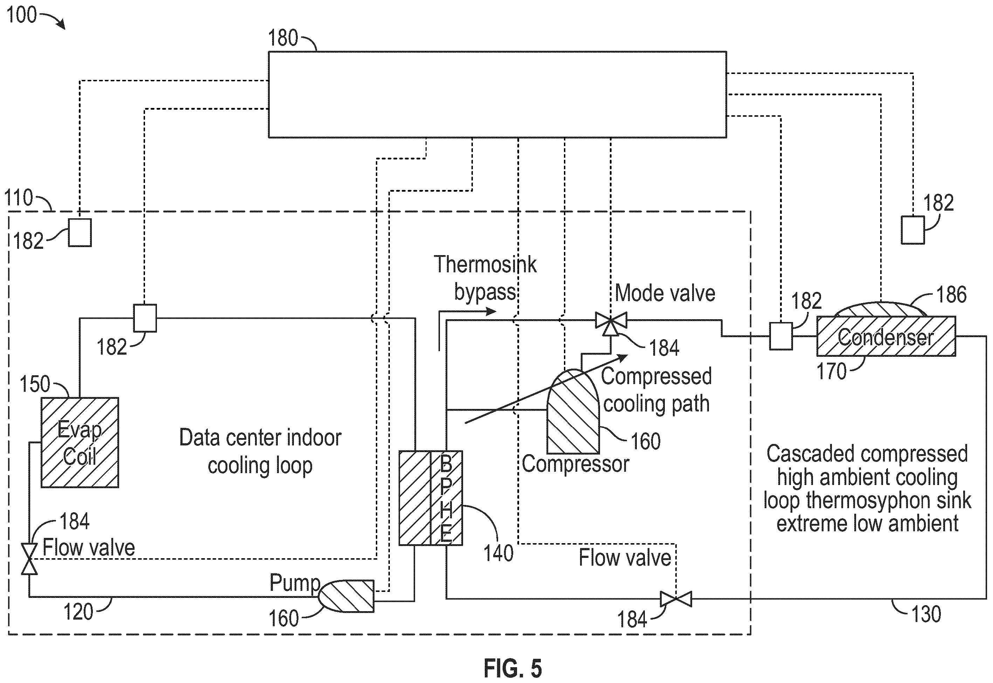

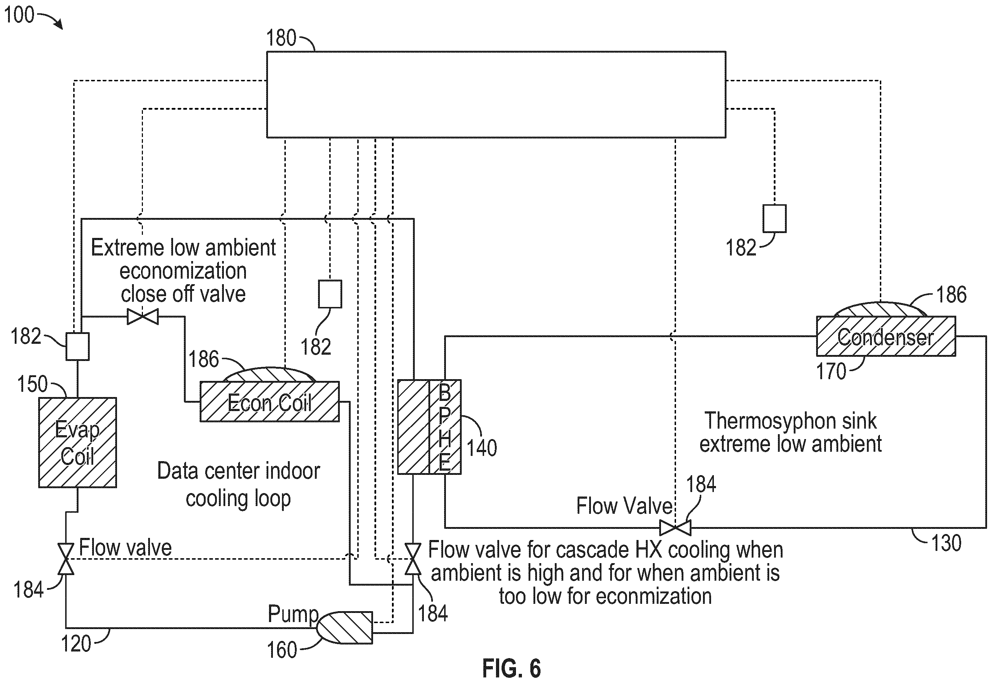

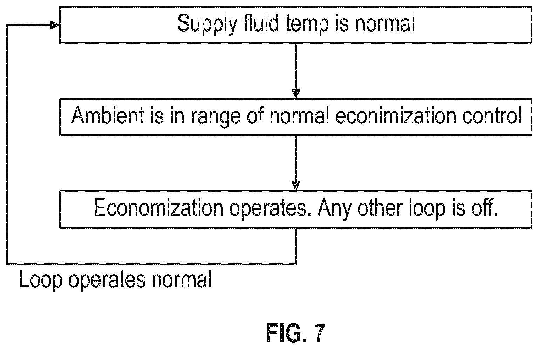

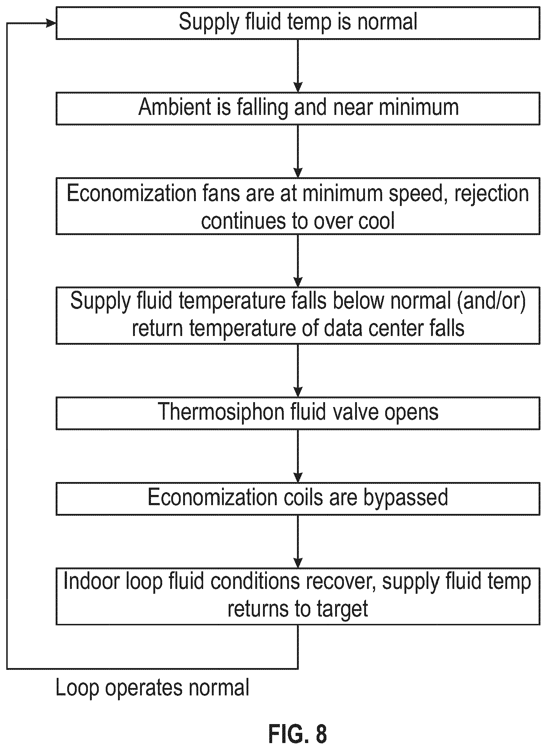

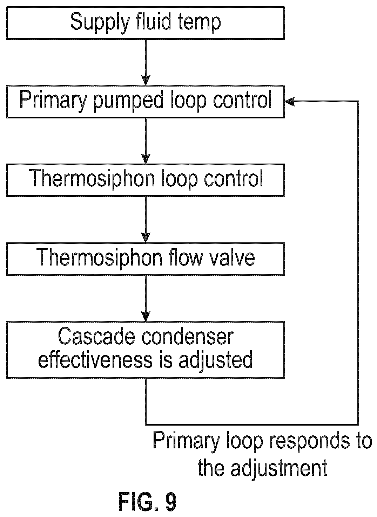

FIG. 1 is a simplified schematic view of one of many embodiments of a cooling system according to the disclosure. FIG. 2 is a simplified schematic view of another one of many embodiments of a cooling system according to the disclosure. FIG. 3 is a simplified schematic view of another one of many embodiments of a cooling system according to the disclosure. FIG. 4 is a simplified schematic view of yet another of many embodiments of a cooling system according to the disclosure. FIG. 5 is a simplified schematic view of still another of many embodiments of a cooling system according to the disclosure. FIG. 6 is a simplified schematic view of another one of many embodiments of a cooling system according to the disclosure. FIG. 7 is a flow chart of one of many embodiments of a control scheme for use with a cooling system according to the disclosure. FIG. 8 is a flow chart of another one of many embodiments of a control scheme for use with a cooling system according to the disclosure. FIG. 9 is a flow chart of yet another one of many embodiments of a control scheme for use with a cooling system according to the disclosure. FIGS. 1-9 are described in conjunction with one another.

In at least one embodiment, a cooling system 100 according to the disclosure can extract heat from within one or more spaces 110, such as a data center, and expel the heat outside the space 110. In at least one embodiment, a cooling system 100 according to the disclosure can include one or more inside loops 120 disposed at least partially within the space 110, one or more outside loops 130 disposed at least partially outside the space 110, one or more heat exchangers 140 for transferring heat from the inside loop 120 to the outside loop 130, or any combination thereof. In at least one embodiment, the heat exchanger 140 can be or include one or more cascade heat exchangers, which can be a brazed plate heat exchanger (BPHE) or another type of fluid-to-fluid heat exchanger. In at least one embodiment, the inside loop 120 can include one or more evaporators 150 for transferring heat from within the space 110, or data center, to a first cooling fluid and/or one or more prime movers 160, such as one or more pumps and/or one or more compressors, for circulating the first cooling fluid within the inside loop 120. In at least one embodiment, the heat exchanger 140 can transfer heat from the first cooling fluid to a second cooling fluid. In at least one embodiment, the outside loop 130 can include one or more condensers 170 for transferring heat from the second cooling fluid to an environment outside the data center 110. In at least one embodiment, the condenser 170 can be mounted at a higher elevation than the heat exchanger 140, and the outside loop 130 can be configurable, or operable, as a thermosiphon.

In at least one embodiment, a cooling system 100 according to the disclosure can include one or more controllers 180 for monitoring one or more temperature sensors 182 In at least one embodiment, the controller 180 can monitor one or more inside temperatures within the data center 110 and/or one or more outside temperatures outside the data center 100, such as using the temperature sensors 182. In at least one embodiment, the controller 180 can control one or more valves 184 to control fluid flow through the inside loop 120 and/or the outside loop 130. In at least one embodiment, the controller 180 can selectively operate the inside loop 120 and/or the outside loop 130 in a thermosiphon mode, such as through control of the valve(s) 184 according to information from the temperature sensor(s) 182. In at least one embodiment, the controller 180 can control one or more fans 186, such as to increase or otherwise control airflow through the evaporator 150 and/or the condenser 170.

In at least one embodiment, the controller 180 can operate the outside loop 130 according to the inside temperature(s) and/or the outside temperature(s). In at least one embodiment, the controller 180 can operate the outside loop 130 in a power-driven mode, such as by inducing fluid flow therethrough using the prime mover 160, such as a pump or compressor, in the outside loop 130. In at least one embodiment, the controller 180 can operate the outside loop 130 in the power-driven mode when the inside temperature(s) are above a first threshold, such as indicating enough heat load in the data center, or other space 110, and/or the outside temperature(s) are above a second threshold, such as indicating warmer ambient temperatures. In at least one embodiment, the controller 180 can operate the outside loop 130 in the thermosiphon mode when the inside temperature is below the first threshold, such as indicating less heat load, and/or the outside temperature is below the second threshold, such as indicating cooler ambient temperatures.

In at least one embodiment, the controller 180 can operate the outside loop 130 according to a difference between the inside temperature(s) and the outside temperature(s). In at least one embodiment, the controller 180 can operate the outside loop 130 in the power-driven mode when a difference between the inside temperature and the outside temperature is below a threshold, such as indicating a small differential temperature across the data center 110 and/or a situation where a thermosyphon could be inefficient and/or ineffective. In at least one embodiment, the controller 180 can operate the outside loop 130 in the thermosiphon mode when the difference is above the threshold, such as indicating a larger differential temperature across the data center 110 and/or a situation where a thermosyphon could be efficient and/or effective.

In at least one embodiment, the controller 180 can operate the outside loop 130 according to the inside temperature and/or the outside temperature and a difference between the inside temperature and the outside temperature. In at least one embodiment, the controller 180 can operate the outside loop 130 in the thermosiphon mode when the inside temperature is below a first threshold and a difference between the inside temperature and the outside temperature is above a second threshold. In at least one embodiment, the controller 180 can operate the outside loop 130 in the thermosiphon mode when a difference between the inside temperature and the outside temperature is above a first threshold and the outside temperature is below a second threshold.

In at least one embodiment, the controller 180 can selectively operate one or more cooling loops in one or more cooling modes, such as either a power-driven mode or a thermosiphon mode. For example, in at least one embodiment, the controller 180 can selectively operate the outside loop 130 in the power-driven mode by energizing one or more compressors 160 and, alternatively, operate the outside loop 130 in the thermosiphon mode by bypassing and/or deenergizing the compressor(s) 160. In at least one embodiment, the at least one valve 184 can include one or more bypass valves for bypassing the compressor 160. In at least one embodiment, the at least one valve 184 can include one or more flow control valves for controlling flow through the inside loop 120 and/or the outside loop 130. In at least one embodiment, the outside loop 130 can include one or more prime movers 160, such as one or more pumps and/or one or more compressors, for circulating the second cooling fluid within the outside loop 130 and the at least one valve 184 can include one or more bypass valves for selectively bypassing the prime mover 160 in the outside loop 130, such as to selectively configure the outside loop 130 as the thermosiphon.

In at least one embodiment, a cooling system according to the disclosure can include another outside loop 132 disposed at least partially outside the data center 110 and/or another heat exchanger 140 for transferring heat from the first cooling fluid to a third cooling fluid. In at least one embodiment, the outside loop 132 can include one or more condensers 170 for transferring heat from the third cooling fluid to the environment outside the data center 110 and/or one or more prime movers 160, such as one or more pumps and/or one or more compressors, for circulating the third cooling fluid within the outside loop 132. In at least one embodiment, the at least one valve 184 can include one or more flow control valve for controlling flow through the inside loop 120, the outside loop 130, the outside loop 132, or any combination thereof. In at least one embodiment, the controller 180 can control flow through the outside loop 132 using the flow control valve independently of the thermosiphon of the outside loop 130.

In at least one embodiment, the inside loop 120 can include an economizer 190, such as a fluid-side economizer, for selectively transferring heat from the first cooling fluid to the environment outside the data center 110. In at least one embodiment, the economizer 190 can share air flow with the condenser 170, such as in series. In at least one embodiment, the controller 180 can bypass the economizer 190 and operate the outside loop 130 in the thermosiphon mode when the inside temperature and/or the outside temperature is below a first and/or second threshold.

In at least one embodiment, the controller 180 can bypass the economizer 190 and operate the outside loop 130 in the thermosiphon mode when a difference between the inside temperature and the outside temperature is above a threshold. In at least one embodiment, the controller 180 can bypass the economizer 190 and operate the outside loop 130 in the thermosiphon mode when the inside temperature is below a first threshold, the outside temperature is below a second threshold, a difference between the inside temperature and the outside temperature is above a third threshold, or any combination thereof. In at least one embodiment, the economizer 190 can be plumbed in parallel with the heat exchanger 140.

In at least one embodiment, the controller 180 can utilize the economizer 190 and operate the second loop 130 in the thermosiphon mode when a difference between the first temperature and the second temperature is above a threshold. In at least one embodiment, the controller 180 can utilize the economizer 190 and operate the second loop 120 in the thermosiphon mode when the first temperature is below a first threshold, the second temperature is below a second threshold, a difference between the first temperature and the second temperature is above a third threshold, or any combination thereof.

In at least one embodiment, a cooling system 100 according to the disclosure can include one or more prime movers, such pumps and/or compressors, in the outside loop 130 that can be operated in the thermosiphon mode. In at least one embodiment, a cooling system 100 according to the disclosure can include one or more prime movers, such pumps and/or compressors, in a separate and/or independent outside loop 132 with respect to the outside loop 130 that can be operated in the thermosiphon mode. In at least one embodiment, a cooling system 100 according to the disclosure can utilize the outside loop 130 in the thermosiphon mode as a finer level of control, such as when heat load, cooling demand, outside ambient temperatures, or any combination thereof, are low and the difference between the temperature of the space 110 and the outside ambient temperature is significant, i.e., sufficient to support thermosiphon mode operation in accordance with a given implementation of the disclosure.

In at least one embodiment, the heat exchanger 140 can be plumbed in the inside loop 120 at an outlet of the evaporator 150, such as to minimize vapor line length when the outside loop 130 is operated in the thermosiphon mode. In at least one embodiment, operating the outside loop 130 in the thermosiphon mode needs no more than the heat exchanger 140, the condenser 170, and elevation changes in the intercoupling piping. In at least one embodiment, operating the outside loop 130 in the thermosiphon mode can include one or more fans 186, such as for inducing air flow through the condenser 170. In at least one embodiment, operating the outside loop 130 in the thermosiphon mode and selectively energizing one or more fans 186, such as for inducing air flow through the condenser 170, can add a further level of fine cooling system control, such as when cooling demand and/or outside ambient temperatures are low. In at least one embodiment, low cooling demand and/or outside ambient temperature control can be improved, such as in terms of efficiency and/or precise control, as described herein. In at least one embodiment, cooling system control can be improved, such as in terms of efficiency and/or precise control, more precisely than by selectively utilizing an economizer 190 and/or selectively operating fans 186.

In at least one embodiment, the heat exchanger 140 can have different thermal efficiencies, such as depending on a flow rate therethrough. In at least one embodiment, the heat exchanger 140 can have a higher thermal efficiency with higher flow rates therethrough, such as when the compressor 160 in the outside loop 130 is in operation and the outside loop 130 is in power-driven mode. In at least one embodiment, the heat exchanger 140 can have a lower thermal efficiency with lower flow rates therethrough, such as when the compressor 160 in the outside loop 130 is bypassed and the outside loop 130 is in thermosiphon mode. In at least one embodiment, a lower thermal efficiency in the heat exchanger 140 can provide more precise control of the cooling system 100. For example, the addition of the thermosiphon as a secondary loop can improve and better control the primary loop's refrigerant conditions. The heat exchanger 140 (e.g., a BPHE) adds cooling resistance for countering larger temperature differences or when loads are small for a standard ambient temperature. In this manner, the less efficient location of an additional (i.e., if one were used on the primary loop with the economizer coils) thermosiphon provides benefits in light of the less efficient location, such as with a cascaded high ambient rejection unit that would otherwise set idle at low ambient.

In at least one embodiment, a method according to the disclosure can include extracting heat from a space 110, such as a data center, using a first loop 120 at least partially within the space 110 and a second loop 130 at least partially outside the space 110. In at least one embodiment, a method according to the disclosure can including monitoring a first temperature within the data center 110, monitoring a second temperature outside the data center 110, energizing a prime mover 160 in the second loop 130 when the first temperature is above a first threshold, deenergizing the prime mover 160 in the second loop 130 when the second temperature is below a second threshold, or any combination thereof. In at least one embodiment, the first temperature can be indicative of a heat load within the data center 110 and/or the second temperature can be indicative of an ambient temperature outside the data center 110.

In at least one embodiment, energizing the prime mover 160, such as a pump or a compressor, in the second loop 130 can include operating the second loop 130 in a power-driven mode, such as when the heat load within the data center 110 is above the first threshold which can indicate a high heat load and/or cooling demand. In at least one embodiment, deenergizing the prime mover 160 in the second loop 130 can include operating the second loop 130 in a thermosiphon mode, such as when the ambient temperature outside the data center 110 is below the second threshold which can indicate cold weather or low ambient temperatures. In at least one embodiment, deenergizing the prime mover 160 in the second loop 130 can include deenergizing the prime mover 160 in the second loop 130 when the first temperature is below the first threshold and the second temperature is below the second threshold, and the second loop 130 can be operated in the thermosiphon mode when the heat load within the data center 110 is below the first threshold and the ambient temperature outside the data center 110 is below the second threshold. In at least one embodiment, deenergizing the prime mover 160 in the second loop 130 can include deenergizing the prime mover 160 in the second loop 130 when a difference between the first temperature and the second temperature is above a third threshold and the second temperature is below the second threshold, and the second loop 130 can be operated in the thermosiphon mode when a differential temperature across the data center 110 is above the third threshold and the ambient temperature outside the data center 110 is below the second threshold.

In at least one embodiment, a method according to the disclosure can include operating the second loop 130 in a power-driven mode when a temperature inside the space 110 is above a first threshold and/or operating the second loop 130 in a thermosiphon mode when the temperature inside the space 110 is below the first threshold. In at least one embodiment, operating the second loop in the thermosiphon mode can include bypassing a compressor 160 in the second loop 130.

In at least one embodiment, a method according to the disclosure can include operating an economizer 190 in the first loop 120 when the temperature inside the space 110 is below the first threshold and above a second threshold and/or when the temperature inside the space 110 is above a third threshold. In at least one embodiment, the second threshold can be lower than the first threshold and/or the third threshold can be higher than the first threshold. In at least one embodiment, the economizer 190 can transfer heat in the first loop 120 to an environment outside the space 110.

In at least one embodiment, a method according to the disclosure can include operating the second loop 130 in a power-driven mode when a first temperature inside the space 110 is above a first threshold, operating the second loop 130 in the power-driven mode when the first temperature inside the space 110 is below the first threshold and above a second threshold and a difference between the first temperature inside the space 110 and a second temperature outside the space 110 is below a third threshold, operating the second loop 130 in a thermosiphon mode when the first temperature inside the space 110 is below the first threshold and above the second threshold and the difference between the first temperature inside the space 110 and the second temperature outside the space 110 is above the third threshold, operating the second loop 130 in the thermosiphon mode when the first temperature inside the space 110 is below the second threshold, or any combination thereof. In at least one embodiment, the second threshold can be lower than the first threshold. In at least one embodiment, operating the second loop 130 in the thermosiphon mode can include bypassing a compressor 160 in the second loop 130.

In at least one embodiment, a method according to the disclosure can include operating an economizer 190 in the first loop 120 when the temperature inside the space 110 is above a fourth threshold, higher than the first threshold. In at least one embodiment, a method according to the disclosure can include operating an economizer 190 in the first loop 120 when the first temperature inside the space 110 is below the first threshold and above a fifth threshold, between the first threshold and the second threshold. In at least one embodiment, the economizer 190 can transfer heat in the first loop 120 to an environment outside the space 110.

In at least one embodiment, a cooling system according to the disclosure can extract heat from within a space, such as a data center, and expel the heat outside the space, or data center. In at least one embodiment, a cooling system according to the disclosure can include a first loop disposed at least partially within the space, or data center, a second loop disposed at least partially outside the space, or data center, a heat exchanger for transferring heat from the first loop to a second loop, or any combination thereof. In at least one embodiment, the first loop can include an evaporator for transferring heat from within the data center to a first cooling fluid and/or a first prime mover, such as a pump or a compressor, for circulating the first cooling fluid within the first loop. In at least one embodiment, the heat exchanger can transfer heat from the first cooling fluid to a second cooling fluid. In at least one embodiment, the second loop can include a condenser for transferring heat from the second cooling fluid to an environment outside the data center. In at least one embodiment, the condenser can be mounted at a higher elevation than the heat exchanger, and the second loop can be configurable or operable as a thermosiphon.

In at least one embodiment, a cooling system according to the disclosure can include a controller for monitoring a first temperature within the data center and/or a second temperature outside the data center. In at least one embodiment, the controller can control at least one valve and/or selectively operate the second loop in a thermosiphon mode. That is, in at least one embodiment, the controller can selectively operate the second loop in either the power-driven mode by energizing a compressor, or the thermosiphon mode by bypassing the compressor.

In at least one embodiment, the controller can operate the second loop according to the first temperature and/or the second temperature. In at least one embodiment, the controller can operate the second loop in a power-driven mode when the first temperature is above a first threshold and/or the second temperature is above a second threshold. In at least one embodiment, the controller can operate the second loop in the thermosiphon mode when the first temperature is below the first threshold and/or the second temperature is below the second threshold.

In at least one embodiment, the controller can operate the second loop according to a difference between the first temperature and the second temperature. In at least one embodiment, the controller can operate the second loop in a power-driven mode when a difference between the first temperature and the second temperature is below a threshold. In at least one embodiment, the controller can operate the second loop in the thermosiphon mode when the difference is above the threshold.

In at least one embodiment, the controller can operate the second loop according to the first temperature and/or the second temperature and a difference between the first temperature and the second temperature. In at least one embodiment, the controller can operate the second loop in the thermosiphon mode when the first temperature is below a first threshold and a difference between the first temperature and the second temperature is above a second threshold. In at least one embodiment, the controller can operate the second loop in the thermosiphon mode when a difference between the first temperature and the second temperature is above a first threshold and the second temperature is below a second threshold.

In at least one embodiment, the controller can operate the second loop in the power-driven mode by energizing a compressor. In at least one embodiment, the controller can operate the second loop in the thermosiphon mode by bypassing the compressor. In at least one embodiment, the at least one valve can include a bypass valve for bypassing the compressor. In at least one embodiment, the at least one valve can include a flow control valve for controlling flow through the second loop. In at least one embodiment, the second loop can include a second prime mover, such as a pump or a compressor, for circulating the second cooling fluid within the second loop and the at least one valve can include a bypass valve for selectively bypassing the second prime mover in order to selectively configure the second loop as the thermosiphon.

In at least one embodiment, a cooling system according to the disclosure can include a third loop disposed at least partially outside the data center and/or another heat exchanger for transferring heat from the first cooling fluid to a third cooling fluid. In at least one embodiment, the third loop can include a condenser for transferring heat from the third cooling fluid to the environment outside the data center and/or another prime mover, such as a pump or a compressor, for circulating the third cooling fluid within the third loop. In at least one embodiment, the at least one valve can include a flow control valve for controlling flow through the third loop. In at least one embodiment, the controller can control flow through the third loop using the flow control valve independently of the thermosiphon of the second loop.

In at least one embodiment, the first loop can include a fluid-side economizer for selectively transferring heat from the first cooling fluid to the environment outside the data center. In at least one embodiment, the economizer can share air flow with the condenser, such as in series. In at least one embodiment, the controller can bypass the economizer and operate the second loop in the thermosiphon mode when the first temperature and/or the second temperature is below a first and/or second threshold.

In at least one embodiment, the controller can bypass the economizer and operate the second loop in the thermosiphon mode when a difference between the first temperature and the second temperature is above a threshold. In at least one embodiment, the controller can bypass the economizer and operate the second loop in the thermosiphon mode when the first temperature is below a first threshold, the second temperature is below a second threshold, a difference between the first temperature and the second temperature is above a third threshold, or any combination thereof. In at least one embodiment, the economizer can be plumbed in parallel with the heat exchanger.

In at least one embodiment, the controller can utilize the economizer and operate the second loop in the thermosiphon mode when a difference between the first temperature and the second temperature is above a threshold. In at least one embodiment, the controller can utilize the economizer and operate the second loop in the thermosiphon mode when the first temperature is below a first threshold, the second temperature is below a second threshold, a difference between the first temperature and the second temperature is above a third threshold, or any combination thereof.

In at least one embodiment, a method according to the disclosure can include extract heat from a space, such as a data center, using a first loop at least partially within the space and a second loop at least partially outside the space. In at least one embodiment, a method according to the disclosure can including monitoring a first temperature within the data center, monitoring a second temperature outside the data center, energizing a prime mover in the second loop when the first temperature is above a first threshold, deenergizing the prime mover in the second loop when the second temperature is below a second threshold, or any combination thereof. In at least one embodiment, the first temperature can be indicative of a heat load within the data center and/or the second temperature can be indicative of an ambient temperature outside the data center.

In at least one embodiment, energizing the prime mover, such as a pump or a compressor, in the second loop can include operating the second loop in a power-driven mode, such as when the heat load within the data center is above the first threshold which can indicate a high heat load and/or cooling demand. In at least one embodiment, deenergizing the prime mover in the second loop can include operating the second loop in a thermosiphon mode, such as when the ambient temperature outside the data center is below the second threshold which can indicate cold weather or low ambient temperatures. In at least one embodiment, deenergizing the prime mover in the second loop can include deenergizing the prime mover in the second loop when the first temperature is below the first threshold and the second temperature is below the second threshold, and the second loop can be operated in the thermosiphon mode when the heat load within the data center is below the first threshold and the ambient temperature outside the data center is below the second threshold. In at least one embodiment, deenergizing the prime mover in the second loop can include deenergizing the prime mover in the second loop when a difference between the first temperature and the second temperature is above a third threshold and the second temperature is below the second threshold, and the second loop can be operated in the thermosiphon mode when a differential temperature across the data center is above the third threshold and the ambient temperature outside the data center is below the second threshold.

In at least one embodiment, a method according to the disclosure can include operating the second loop in a power-driven mode when a temperature inside the space is above a first threshold and/or operating the second loop in a thermosiphon mode when the temperature inside the space is below the first threshold. In at least one embodiment, operating the second loop in the thermosiphon mode can include bypassing a compressor in the second loop.

In at least one embodiment, a method according to the disclosure can include operating an economizer in the first loop when the temperature inside the space is below the first threshold and above a second threshold and/or when the temperature inside the space is above a third threshold. In at least one embodiment, the second threshold can be lower than the first threshold and/or the third threshold can be higher than the first threshold. In at least one embodiment, the economizer can transfer heat in the first loop to an environment outside the space.

In at least one embodiment, a method according to the disclosure can include operating the second loop in a power-driven mode when a first temperature inside the space is above a first threshold, operating the second loop in the power-driven mode when the first temperature inside the space is below the first threshold and above a second threshold and a difference between the first temperature inside the space and a second temperature outside the space is below a third threshold, operating the second loop in a thermosiphon mode when the first temperature inside the space is below the first threshold and above the second threshold and the difference between the first temperature inside the space and the second temperature outside the space is above the third threshold, operating the second loop in the thermosiphon mode when the first temperature inside the space is below the second threshold, or any combination thereof. In at least one embodiment, the second threshold can be lower than the first threshold. In at least one embodiment, operating the second loop in the thermosiphon mode can include bypassing a compressor in the second loop.

In at least one embodiment, a method according to the disclosure can include operating an economizer in the first loop when the temperature inside the space is above a fourth threshold, higher than the first threshold. In at least one embodiment, a method according to the disclosure can include operating an economizer in the first loop when the first temperature inside the space is below the first threshold and above a fifth threshold, between the first threshold and the second threshold. In at least one embodiment, the economizer can transfer heat in the first loop to an environment outside the space.

Other and further embodiments utilizing one or more aspects of the disclosure can be devised without departing from the scope of Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other embodiments and not every embodiment of the inventions has been described. Obvious modifications and alterations to the described embodiments are available to those of ordinary skill in the art having the benefits of the present disclosure. The disclosed and undisclosed embodiments are not intended to limit or restrict the scope or applicability of the inventions conceived of by the Applicant, but rather, in conformity with the patent laws, Applicant intends to fully protect all such modifications and improvements that come within the scope of the following claims.

## Claims

1. A cooling system for extracting heat from within a data center and expelling the heat outside the data center, the system comprising:
a first loop disposed at least partially within the data center, the first loop comprising:
an evaporator configured to transfer heat from within the data center to a first cooling fluid; and
a first prime mover configured to circulate the first cooling fluid within the first loop;
a first heat exchanger configured to transfer heat from the first cooling fluid to a second cooling fluid; and
a second loop disposed at least partially outside the data center, the second loop comprising:
a condenser configured to transfer heat from the second cooling fluid to an environment outside the data center;
wherein the condenser is mounted at a higher elevation than the first heat exchanger, and the second loop is configurable as a thermosiphon.

2. The system of claim 1, further including a controller configured to monitor a first temperature within the data center and a second temperature outside the data center, the controller being configured to control at least one valve to selectively operate the second loop in a thermosiphon mode.

3. The system of claim 2, wherein the controller is configured to operate the second loop in a power-driven mode when the first temperature is above a first threshold, the second temperature is above a second threshold, or both.

4. The system of claim 2 or 3, wherein the controller is configured to operate the second loop in the thermosiphon mode when either the first temperature is below a first threshold or the second temperature is below a second threshold.

5. The system of claim 2, 3 or 4, wherein the controller is configured to operate the second loop in a power-driven mode when a difference between the first temperature and the second temperature is below a threshold, and optionally wherein the controller is configured to operate the second loop in the thermosiphon mode when the difference is above the threshold.

6. The system of any of claims 2 to 5, wherein the controller is configured to operate the second loop in the thermosiphon mode when the first temperature is below a first threshold and a difference between the first temperature and the second temperature is above a second threshold.

7. The system of any of claims 2 to 6, wherein the controller is configured to operate the second loop in the thermosiphon mode when a difference between the first temperature and the second temperature is above a first threshold and the second temperature is below a second threshold, and/or wherein the controller is configured to selectively operate the second loop in either the power-driven mode by energizing a compressor, or the thermosiphon mode by bypassing the compressor.

8. The system of any of claims 2 to 7, wherein the at least one valve includes a flow control valve configured to control flow through the second loop.

9. The system of any of claims 2 to 8, wherein the second loop includes a second prime mover configured to circulate the second cooling fluid within the second loop; and wherein the at least one valve includes a bypass valve configured to selectively bypass the second prime mover to selectively configure the second loop as the thermosiphon.

10. The system of any of claims 2 to 9, further comprising:
a second heat exchanger configured to transfer heat from the first cooling fluid to a third cooling fluid; and
a third loop disposed at least partially outside the data center, the third loop comprising:
a condenser configured to transfer heat from the third cooling fluid to the environment outside the data center; and
a second prime mover configured to circulate the third cooling fluid within the third loop;
wherein the at least one valve includes a flow control valve configured to control flow through the third loop; and
wherein the controller is configured to control flow through the third loop using the flow control valve independently of the thermosiphon of the second loop.

11. The system of any of claims 2 to 10, wherein the first loop includes a fluid-side economizer configured to selectively transfer heat from the first cooling fluid to the environment outside the data center.

12. The system of claim 11, wherein the economizer is configured to share air flow with the condenser in series and/or wherein the economizer is plumbed in parallel with the first heat exchanger.

13. The system of claim 11 or 12, wherein the controller is configured to bypass the economizer and operate the second loop in the thermosiphon mode when the first temperature is below a threshold.

14. The system of claim 11, 12 or 13, wherein the controller is configured to bypass the economizer and operate the second loop in the thermosiphon mode when the second temperature is below a threshold, and/or wherein the controller is configured to bypass the economizer and operate the second loop in the thermosiphon mode when a difference between the first temperature and the second temperature is above a threshold.

15. The system of any of claims 11 to 14, wherein the controller is configured to bypass the economizer and operate the second loop in the thermosiphon mode when the first temperature is below a first threshold, the second temperature is below a second threshold, and a difference between the first temperature and the second temperature is above a third threshold, and/or wherein the controller is configured to utilize the economizer and operate the second loop in the thermosiphon mode based, at least in part, on the first temperature, the second temperature, or a combination of the first temperature and the second temperature.
